# EUROPÄISCHE PATENTSCHRIFT

(11) **EP 2 714 964 B1**
(45) Veröffentlichungstag und Bekanntmachung des Hinweises auf die Patenterteilung: **08.07.2015**
(21) Anmeldenummer: 12724539.7
(22) Anmeldetag: 25.05.2012
(51) Int. Cl.: C23C 30/00, C23C 28/04, C23C 14/06

(54) **BESCHICHTETES HOLZBEARBEITUNGSWERKZEUG**
WOOD WORKING TOOL
OUTIL POUR L'USINAGE DU BOIS

(30) Priorität: 27.05.2011 CH 911112011
(43) Veröffentlichungstag der Anmeldung: 09.04.2014
(73) Patentinhaber: W. Blösch AG, 2540 Grenchen (CH)
(72) Erfinder: DUTTLINGER, Roland, 79771 Klettgau-Erzingen (DE); SCHINDLER, Mauro, CH-1700 Fribourg (CH); BLOSCH, Peter, CH-2502 Biel (CH)
(74) Vertreter: Hasler, Erich
(86) Internationale Anmeldenummer: PCT/CH2012/000120
(87) Internationale Veröffentlichungsnummer: WO 2012/162849

(56) Entgegenhaltungen:
- EP-A2- 0 534 905
- DD-A1- 202 898
- DE-A1- 4 009 994
- DE-A1- 19 511 829
- DE-A1- 19 825 572
- DE-C1- 4 414 051
- US-B1- 6 716 483
- RECHBERGER J ET AL: "High performance cutting tools with a solid lubricant physically vapour- deposited coating", SURFACE AND COATINGS TECHNOLOGY, ELSEVIER, AMSTERDAM, NL, Bd. 62, Nr. 1-3, 10. Dezember 1993 (1993-12-10), Seiten 393-398, XP024500250, ISSN: 0257-8972, DOI: 10.1016/0257-8972(93)90273-Q [gefunden am 1993-12-10]
- GOTTLÖBER, CHRISTIAN: 'Zerspanung von Holz und Holzwerkstoffen', Seite 187
- 'Molybdän(IV)sulfid', [Online] online encyclopedia wikipedia Gefunden im Internet: <URL:http://de.wikipedia.org/wiki/Molybd%C3 %A4n%28IV%29-sulfid> [gefunden am 2014-06-24]

## Beschreibung

Die vorliegende Erfindung betrifft ein beschichtetes Holzbearbeitungswerkzeug gemäss Anspruch 1 sowie ein Verfahren zur Herstellung eines solchen gemäss Anspruch 12.

### STAND DER TECHNIK

Schneidwerkzeuge zeichnen sich durch eine oder viele an einem Schaft oder Blatt angebrachte keilförmige Schneiden aus, die zur Formgebung eines Werkstücks durch Trennen dienen. Je nach Art des Trennvorgangs unterscheidet man dabei Zerspanungswerkzeuge für spanabhebende und Schneidwerkzeuge für zerteilende Fertigungsverfahren (s. www.wikipedia.de, Stichwort: Schneidwerkzeug).

Je nach Art des zu bearbeitenden Werkstoffs müssen die eingesetzten Schneidwerkzeuge unterschiedliche Anforderungen erfüllen. Bei der zerspanenden Bearbeitung eines metallischen Werkstücks, z.B. eines Schnellarbeitsstahls (HSS) ergeben sich am Schneidkeil Temperaturen zwischen 800 und 1200 °C. Dabei kommt es an den Oberflächen zu chemischen Reaktionen, wie Diffusions- und Oxidationsvorgängen. Das Schneidwerkzeug ist zudem einer hohen mechanischen und thermischen Wechselspannung ausgesetzt. Die Folge davon sind Abrieb der Schneidflächen, auftretende Kammrisse, Ausbrüche der Schneidkante, plastische Deformationen, Erosion der Schneidspitze (Kolkverschleiss) etc.

Aufgrund der im Vergleich zu Metallen geringen Dichte von Holz (< 1 g/cm3) werden an Schneidwerkzeuge für die Holzbearbeitung grundsätzlich unterschiedliche Anforderungen gestellt. Holz ist ein anisotroper Werkstoff mit einer faserigen Struktur, besitzt in der Regel eine Restfeuchte von meist > 10% und enthält Harze und Gerbstoffe. Entsprechend unterschiedlich ist auch der Schneidenverschleiss verglichen mit Metallbearbeitungswerkzeugen. Im Unterschied zu Metallbearbeitungswerkzeugen kommt der Verschleiss bei Holzwerkzeugen in erster Linie durch Abrasion zustande, aber auch die Korrosion und Verharzung der Schneiden spielen eine grosse Rolle. Für den Fachmann ist daher klar, dass aufgrund der unterschiedlichen Anforderungen an Holz- und Metallbearbeitungswerkzeuge das Wissen aus der Herstellung von Metallwerkzeugen nicht ohne weiteres auf Holzbearbeitungswerkzeuge übertragen werden.

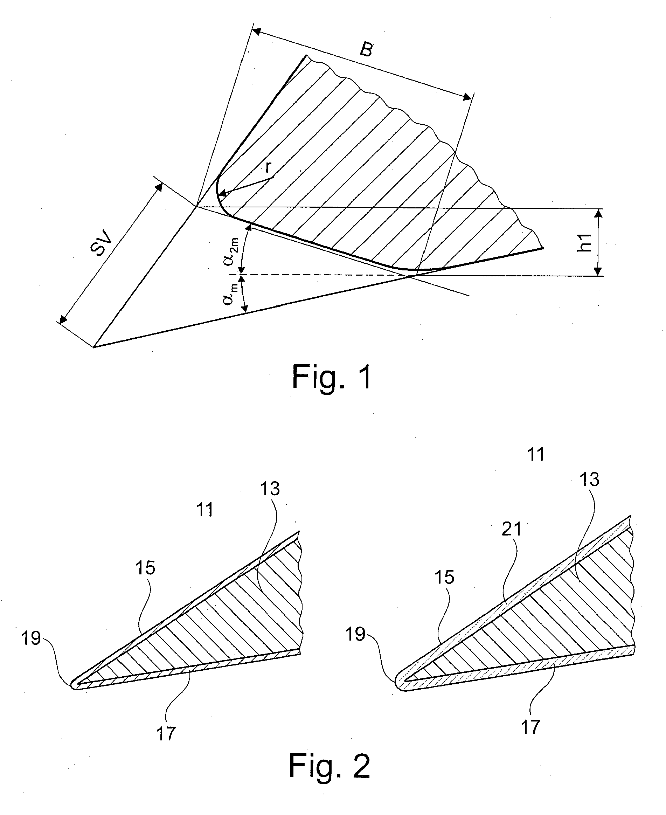

Im Unterschied zum Metallzerspanen, wo das Metall quasi "weggerissen" wird (d.h. es fliesst), müssen die Holzfasern beim Holzzerspanen sauber durchtrennt werden. Entsprechend weisen die Schneidkanten von Holzbearbeitungswerkzeugen im Vergleich zu Metallbearbeitungswerkzeugen kleinere Schneidkantenverrundungen auf. Unter Schneidkantenverrundung ist im Rahmen der vorliegenden Anmeldung der Radius r der eigentlichen Schneidkante zu verstehen (Fig. 1). Dieser Radius liegt bei neuen, geschärften Holzwerkzeugen in der Regel im Bereich von 1 bis 4 Mikrometern. Sobald die Schneide etwas abgenutzt ist (Verrundung > 10 µm), beginnt sie zu drücken und staucht die Holzfasern. Die bearbeitete Holzoberfläche sieht dann im ersten Moment noch gut aus, aber wenn sie lackiert wird, stellen sich die gedrückten Fasern wieder auf, was zu einem unbrauchbaren Ergebnis auf der Oberfläche führt. Zusätzlich entsteht bei der Bearbeitung mit einer nicht mehr "scharfen" Schneide ein massiv erhöhter Anteil Staub mit einer Korngrösse < 100 µm, da die Faser nicht geschnitten sondern zerschlagen wird.

Im Vergleich zu Holzbearbeitungswerkzeugen beträgt die Schneidkantenverrundung bei Metallschneidwerkzeugen in der Regel deutlich mehr als 10 Mikrometer. Ein weiterer Unterschied zwischen Metall- und Holzbearbeitungswerkzeugen liegt in der Regel im Keilwinkel. Dieser beträgt bei Holzwerkzeugen üblicherweise zwischen etwa 40 und 60 Grad, vorzugsweise zwischen ca. 45 und 55 Grad bei Werkzeugen für die Zerspanung von Massivholz u.ä., und bei Metallbearbeitungswerkzeugen in der Regel > 70 Grad. In speziellen Anwendungen, wo sehr scharfe Schneiden nötig sind, werden in der Holzbearbeitung auch Schneiden mit sehr kleinen Keilwinkeln von weniger als 40 Grad, z.B. 16 bis 20 Grad eingesetzt. Die unterschiedlichen Keilwinkel von Holz- und Metallbearbeitungswerkzeugen sind bedingt durch die im Betrieb auf die Schneidwerkzeuge wirkenden unterschiedlichen Kräfte.

Um die Standzeit der Werkzeuge zu erhöhen, werden bereits seit längerer Zeit Schneidwerkzeuge mit Hartstoffschichten beschichtet. Hartstoffschichten dienen der Verschleissminderung und werden insbesondere bei den Metallschneidwerkzeugen, weniger bei den Holzschneidwerkzeugen, eingesetzt. Bekannte Hartstoffschichten für Metallbearbeitungswerkzeuge bestehen aus TiC, TiN, TiCN, TiAlN, WC, Al₂O₃, BC, SiC, VC, CrN oder anderen keramischen Verbindungen. Bekannt ist auch der Einsatz von polykristallinen Werkzeugen (sog. PKD-Werkzeugen) und von diamantbeschichteten Werkzeugen. Die Hartstoffschichten können in bekannter Weise mittels PVD- (physical vapor deposition), CVD (chemical vapor desposition)- und anderer dem Fachmann bekannten Verfahren aufgebracht werden.

Das US Patent Nr. 7,144,208 beschreibt ein Metallbearbeitungswerkzeug in Gestalt eines Leichtlaufgewindebohrers hergestellt aus einem Molybdän angereicherten Schnellarbeitsstahl, welcher mit einer verschleissfesten und reibungsverminderenden Beschichtung aus Metall-Nitriden, -Carbiden, -Carbonitriden, -Boriden oder -Oxiden versehen ist. Es wird dabei unterschieden zwischen einem ersten äusseren Beschichtungsbereich, welcher beim Schneidvorgang in Kontakt mit dem Werkzeug ist, und einem zweiten inneren Beschichtungsbereich, welcher eine harte, temperaturbeständige Beschichtung aufweist. Der äussere Beschichtungsbereich kann eine einzelne Schicht mit guten tribologischen Eigenschaften, wie beispielsweise Molybdändisulfid, umfassen. Alternativ kann die äussere Beschichtung Molybdändisulfid und eine metallische Beimengung von Mo, Cr, Nb und/oder Ti aufweisen. Es wird weiter vorgeschlagen, alternierende Schichten von Molybdändisulfid und der metallischen Beimengung jeweils einer Stärke zwischen 0.1 und 500 Nanometern aufzubringen. Die Gesamtstärke der Beschichtung soll zwischen 0.1 und 10 Mikrometern betragen. Die zweite innere Beschichtung kann beispielsweise alternierende Schichten von Titannitrid und Siliziumnitrid in einer Gesamtstärke zwischen 0.5 und 20 µm aufweisen. Zusätzlich kann eine metallische Haftschicht bestehend aus oder enthaltend Al, Si, Ti, Cr, W oder Zr direkt auf das Grundmaterial aufgebracht sein. Die Haftschicht kann dabei auch Nitridschichten der vorerwähnten Metalle und eine Stärke zwischen 1 und 3000 Nanometern aufweisen.

Die US 7,147,939 offenbart ebenfalls ein Metallbearbeitungswerkzeug, nämlich einen beschichteten Karbidgewindebohrer, dessen Grundmaterial mit einer verschleissfesten Beschichtung aus Metallnidriden, - carbiden, -carbonitriden, - boriden und/oder -oxiden beschichtet ist. Diese Beschichtung kann mit einer äusseren reibungsvermindernden Schicht aus MoS₂ oder MoS₂ und Übergangsmetallen beschichtet sein. Sowohl die verschleissfeste Grundschicht als auch die reibungsvemindernde Deckschicht können in Form einer Mehrzahl von alternierenden Schichten aufgebracht sein. Darüber hinaus kann das Grundmaterial des Werkzeugs mit einer metallischen Haftschicht versehen sein. Auch kann zwischen der verschleissfesten Schicht und der reibungsvemindernden Schicht eine metallische Zwischenschicht vorgesehen sein.

Wie insbesondere aus den Figuren 2 bis 8 der US 7,147,939 deutlich hervorgeht, wird durch die Beschichtung der Radius der Schneidkante deutlich vergrössert. In den gezeigten Ausführungsbeispielen wird der Schnittkantenradius - wie aus den Figuren herauslesbar ist - durch die Beschichtung mehr als verdoppelt. Übertragen auf ein Holzbearbeitungswerkzeug würden somit Schnittkantenradien entstehen, die nicht kompatibel mit der Definition einer scharfen Schneide stünden.

Molybdändisulfid (MoS₂) ist eine Verbindung mit einem schichtartigen Aufbau ähnlich dem Graphit. Es besitzt zwar einen sehr hohen Schmelzpunkt von über 2000 °C, wird an der Luft jedoch bereits ab 315 °C oxidiert (Sublimationstemperatur liegt bei 450 °C). Unter Ausschluss von Sauerstoff ist die Anwendung bis 1100 °C möglich. Da Holzbearbeitungswerkzeuge während des Schneidvorgangs nicht gekühlt und dementsprechend sehr heiss werden können, wurde Molybdändisulfid als Gleitschicht bei Holzbearbeitungswerkzeugen bisher nicht in Betracht gezogen. MoS₂ ist auch als eine weiche Verbindung bekannt, welche sich in feuchter Umgebung rasch verschlechtert.

Gemäss der EP-A-2 279 837 ist neben der Verschleissbeständigkeit die Korrosionsbeständigkeit eines der Hauptprobleme bei beschichteten Holzwerkzeugen. Durch einen höheren Restfeuchtigkeitsgehalt des Holzes wird die Auswaschung des Chroms aus einer CrN - Verschleissbeschichtung beschleunigt. Zur Lösung dieses Problems schlägt die EP-A-2 279 837 vor, die chromhaltige Grundschicht direkt oder indirekt mit einer chromoxidhaltigen Schicht zu beschichten. Gemäss einer Ausführungsform werden chromresp. chromnitridhaltige und chromoxidhaltige Schichten abwechslungsweise mindestens auf die Spanfläche des Schneidwerkzeugs aufgebracht, sodass die Beschichtung auch nach dem Schärfen des Schneidwerkzeugs, welches in der Regel an der Freifläche vorgenommen wird, erhalten bleibt.

Die DE-A-195 11 829 offenbart ein Schneidwerkzeug, wie Bohrer, Fräser, Gewindebohrer etc., welches besonders geeignet ist, für die Trockenbearbeitung oder die Bearbeitung mit reduzierter Kühlmittelmenge von Leichtmetallen, wie Aluminium/Magnesiumlegierungen. Dabei ist das Schneidteil mit einer Hartstoffschicht einer Stärke zwischen 1 und 10 µm und einer Vickers Härte zwischen 2000 und 10 000 beschichtet. Auf der Hartstoffschicht ist eine Gleitschicht einer Stärke zwischen 0.01 und 5 µm und einer Mohs Härte zwischen 1 und 2 aufgebracht. Die verschleissfeste Schicht besteht dabei vorzugsweise aus TiN, TiAlN, TiCN, Diamant, und die Gleitschicht aus Sulfiden, Seleniden, Telluriden der Übergangsmetalle Nb, Ta, Mo und W. Von Bedeutung ist, dass die Gleitschicht in einem Abstand vor den Hauptschneiden endet, sodass letztere durch die harte, verschleissfeste Grundschicht gebildet ist.

Die EP-A-1 209 254 bezieht sich auf ein Schneidwerkzeug zum Zerspanen, welches mit einer Schicht der Zusammensetzung MeSₓN_{y} mit Me = Ti, Zr oder Hf und 0,1 ≤ y ≤ 0,9 und 0,1 ≤ x ≤ 2,2 beschichtet ist. Die Schichtstärke beträgt zwischen 1 und 5 µm. Von der Verwendung einer Feststoffschmierschicht bestehend aus MoS2 wird abgeraten, da es dieser an der erforderlichen Härte und einer ausreichenden Haftfestigkeit mangelt.

Die EP-A-1 170 398 bezieht sich auf einen Schneideinsatz zum Zerspanen von rostfreiem Stahl, wobei der Schneideinsatz mit einer Feststoffschmierschicht aus MeSₓ mit 0,8 ≤ x ≤ 2,2 und Me = Ti, Zr oder Hf beschichtet ist. Die Feststoffschmierschicht weist eine Dicke zwischen 0,5 und 1 µm auf.

Das deutsche Patent Nr. 2 02 898 offenbart ein Hartstoff- und Festkörperschmierstoffschichtsystem, welches mittels Sputtern auf Schnitt-, Stanz-, Zieh- und Zerspanungswerkzeuge aufgebracht ist. Dabei ist der zuerst aufgebrachten Hartstoffschicht eine Schicht mit hexagonaler Gitterstruktur, insbesondere MoS2, überlagert. Die Gesamtschichtdicke des Hartstoff und Festkörperschmierstoffschichtsystems liegt im Bereich von 0,1 bis 1 µm.

Die EP-A-0 534 905 offenbart Werkzeuge für die zerspanende Bearbeitung von Werkstoffen, welche mit einer Festkörperschmierstoffschicht, vorzugsweise MoS2, beschichtet sind. Die Beschichtung erfolgt bei Temperaturen von unter 550 °C mittels Kathodenzerstäubung. Von Bedeutung ist, dass gemäss Lehre der EP-A-0 534 905 keine Hartstoffschicht zum Einsatz gelangt, sondern die MoS₂ - Schicht direkt auf das Werkstück aufgebracht wird. Die Werkzeuge werden für die Bearbeitung von Leichtmetallen verwendet.

Die DE-A-198 25 572 offenbart ein Werkzeug aus einem Hartmetall-, Cermet-, Keramik- oder Stahlgrundkörper und wenigstens einer darauf abgeschiedenen Schicht, wobei die äusserste Schicht im Wesentlichen aus MoS₂ besteht. Um die Haftung und Oxidationsbeständigkeit zu verbessern, hat die erwähnte Schicht einen Chlorgehalt von 0,5 bis 6 Atom - %.

Die DE-A-196 22 823bezieht sich auf einen Verbundwerkstoff bestehend aus einem Substratkörper und einer darauf abgeschiedenen Hartstoffschicht, wobei die äusserste Schicht eine dispersive zweite Phase aus mindestens einem Sulfid und/oder Selenid eines Metalles der IVa-, Va. und/oder VIa- Gruppe des Periodensystems enthält. Vorzugsweise wird als zweite Phase TiSₓ eingesetzt, wobei x zwischen 1 und 2 liegen kann.

Die oben zitierten Entgegenhaltungen beziehen sich alle auf Metallbearbeitungswerkzeuge, welche in der Regel im Betrieb mit einer Kühlflüssigkeit gekühlt werden. Dies ist jedoch bei der Bearbeitung von Holz nicht möglich.

US Patent Nr. 6,716,483 offenbart schliesslich ein Holzschneidewerkzeug mit einer relativ harten ersten Schicht und einer reibungsvermindernden zweiten Schicht, welche auf der ersten Schicht aufgebracht ist. Gemäss Lehre der US 6,716,483 ist das Werkzeug eine bestimmte Zeit auf eine sehr tiefe Temperatur abzukühlen, um die Mikrostruktur des Werkzeuggrundkörpers wie auch der Beschichtung zu verändern.

### AUFGABE

Es ist nun Aufgabe der Erfindung ein beschichtetes Zerspanungswerkzeug für die Holzbearbeitung bereitzustellen, welches eine möglichst lange Standzeit aufweist. Ein weiteres Ziel ist es, ein Holzbearbeitungswerkzeug mit einer verbesserten "Schnittigkeit" bereitzustellen, welches zu einer geringeren Staubentwicklung beim Schneidvorgang als bei konventionellen Werkzeugen führt. Insbesondere soll der Anteil von Staub mit einer Partikelgrösse < 100 µm verringert werden. Ein weiteres Ziel ist es, ein Werkzeug bereitzustellen, welches beim bearbeiteten Holzwerkstück eine hohe Oberflächengüte erzeugt. Noch ein Ziel ist es, ein Holzzerspanungswerkzeug vorzuschlagen, welches kostengünstig in wenigen Arbeitsgängen herstellbar ist.

### BESCHREIBUNG

Diese und andere Ziele werden durch die Merkmale der unabhängigen Patentansprüche erreicht. Weiterbildungen und/oder vorteilhafte Ausführungsvarianten der Erfindung sind Gegenstand der abhängigen Patentansprüche.

Die Erfindung bezieht sich auf ein beschichtetes Holzbearbeitungswerkzeug, insbesondere Zerspanungswerkzeug, welches einen Werkzeugkörper mit einem Schneidteil aufweist. Am Schneidteil ist eine Schneidkante mit einer Schneidkantenverrundung < 10 µm und vorzugsweise < 5 µm ausgebildet, wie sie für Holzwerkzeuge typisch ist. Solche Holzbearbeitungswerkzeuge sind weiter dadurch charakterisiert, dass der Keilwinkel des Schneidteils weniger als 65 Grad beträgt. Wenigstens die Spanfläche des Schneidteils oder idealerweise die ganze Schneide, inklusive der Schneidkante, ist mit einer Hartstoffschicht beschichtet, wobei die Hartstoffschicht auch mehrlagig sein und unterschiedliche Zusammensetzungen besitzen kann. Als Holzbearbeitungswerkzeug im Rahmen der vorliegenden Erfindung gelten beispielsweise Messer, Schneiden, Wendemesser, Bohrer, Fräser etc.

Erfindungsgemäss ist auf der Hartstoffschicht eine Gleitschicht enthaltend Sulfide, Telluride oder Selenide, insbesondere Sulfide, Telluride oder Selenide mit Übergangsmetallen wie Mo, Nb oder Ta, aufgebracht, welche für ihre vorteilhaften tribologischen Eigenschaften bekannt sind. Überraschenderweise wurde gefunden, dass eine erfindungsgemässe Gleitschicht resp. Feststoffschmierschicht, beispielsweise eine Molybdändisulfid-Beschichtung trotz Sauerstoffempfindlichkeit und niedriger Sublimationstemperatur zu einer bedeutend längeren Standzeit der damit beschichteten Holzsbearbeitungswerkzeuge führt. Ein möglicher Grund für dieses überraschende Ergebnis ist, dass durch die reibungsvermindernde Beschichtung das Holzbearbeitungswerkzeug weit weniger stark als üblich erwärmt wird. Auch könnte die chemische Affinität zwischen Holz und den eingesetzten Schwefelverbindungen der Gleitschicht eine Rolle spielen. Die Erfinder haben zu ihrer Überraschung auch festgestellt, dass die Oberflächengüte von Holzwerkstücken, insbesondere von solchen aus Massivholz, die mit eine erfindungsgemässe Beschichtung aufweisenden Schneidwerkzeugen zerspant wurden, deutlich besser war als von solchen Holzwerkstücken, die mit konventionellen, unbeschichteten Schneidwerkzeugen oder solchen, welche lediglich eine Hartstoffschicht aufwiesen, bearbeitet wurden. Dabei wiesen die eingesetzten Schneidwerkzeuge in beiden Fällen im Rahmen der Messgenauigkeit die gleichen Schneidkantenverrundungen auf, sodass eigentlich erwartet werden konnte, dass das Ergebnis gleich ausfallenwürde. Überraschenderweise konnte auch mit Holzbearbeitungswerkzeugen, deren Schneide mit einer Hartstoffschicht beschichtet war, nicht die gleiche Oberflächengüte erreicht werden, wie mit Schneidwerkzeugen mit einer erfindungsgemässen Gleitschicht. Die Messung der Oberflächengüte wurde subjektiv vorgenommen, indem mit der Handfläche über das bearbeitete Holz gestrichen wurde. Vergleichsversuche mit verschiedenen Personen zeigten, dass diese Art der Messung der Oberflächengüte durchaus brauchbare Ergebnisse lieferte. Die erfindungsgemässen Schneidwerkzeuge eignen sich nicht nur für die Bearbeitung von Massivholz, sondern auch von geklebten Hölzern wie Spanplatten oder keilverzinkte, geklebte Hölzer, die durch die enthaltenen Klebstoffe besonders abrasiv sind. Zur Überraschung der Erfinder wurde zudem festgestellt, dass beim Zerspanen von Holz mit einem erfindungsgemässen Holzbearbeitungswerkzeug über die Lebensdauer des Werkzeugs ungefähr 25% weniger Feinstaubpartikel (Partikelgrösse < 100 □m) erzeugt wurden.

Vorteilhaft enthält die Gleitschicht MoS₂, NbS₂, TaS₂, WS₂, MoSe₂, NbSe₂, TaSe₂, WSe₂, MoTe₂, NbTe₂, WTe₂ oder deren Mischverbindungen sowie nanostrukturiere Schichten bestehend aus letzteren genannten Verbindung als wesentlichen Bestandteil. Unter "wesentlichem Bestandteil" soll dabei im Rahmen der vorliegenden Erfindung ein gewichtsmässiger Anteil von mehr als 50%, vorzugsweise mehr als 70% und besonders bevorzugt mehr als 90% der fraglichen Verbindung oder Mischverbindung verstanden werden. Der restliche, gewichtsmässige Anteil kann beispielsweise ein Metall aus der Nebengruppe IVb, Vb oder VIb des Periodensystems, insbesondere Ti, Zr, Hf, W, V, Ta, Cr, Mo oder Nb sein. Vorzugsweise wird ein solcher Anteil eines oder mehrer der vorerwähnten Metalle der Sulfide, Telluride oder Selenide enthaltenden Gleitschicht beigemengt, dass die Metalle sich in der Gleitschicht lösen.

Zweckmässigerweise hat die Stärke der Gleitschicht eine untere Grenze von 0.2 µm, vorzugsweise von 0.5 µm, und besonders bevorzugt von 0.8 µm. Als obere Grenze ist eine Schichtdicke von 3 µm, vorzugsweise 2 µm, und besonders bevorzugt von 1.5 µm bevorzugt. Für besondere Anwendungen kann die Gleitschicht jedoch auch eine Stärke von mehr als 3 µm aufweisen, obwohl die bisherigen Erfahrungen darauf hinweisen, dass Schichtstärken von mehr als 3 µm zu keiner wesentlichen Verlängerung der Standzeiten führen.

Obwohl bisher davon ausgegangen wurde, dass die Schneidkantenverrundung durch eine Beschichtung entsprechend der Stärke der Beschichtung zunehmen würde, zeigten Messungen, dass die Schneidkantenverrundung durch die Beschichtung mit einer Hartstoffschicht und einer erfindungsgemäßen Gleitschicht nur unwesentlich zunimmt, obwohl die Schneidkante - im Unterschied zur Lehre der DE-A-195 11 829 - ebenfalls beschichtet wurde. Die Zunahme der Schneidkantenverrundung konnte auf weniger als 50%, vorzugsweise weniger als 40% und besonders bevorzugt weniger als 30% der auf der Span- und/oder Freifläche des Schneidwerkzeugs aufgebrachten Schichtdicken begrenzt werden. Dies hat den Vorteil, dass auf eine nachträgliche Bearbeitung des beschichteten Holzbearbeitungswerkzeugs verzichtet werden kann.

Vorteilhaft weist die Stärke (Dicke) der Hartstoffschicht des beschichteten Holzbearbeitungswerkzeugs an der Spanfläche eine untere Grenze von 0.5 µm, vorzugsweise von 1 µm, und besonders bevorzugt von 1.5 µm, und vorzugsweise eine obere Grenze von 7 µm, vorzugsweise 5 µm, und besonders bevorzugt von 3.5 µm auf. Versuche haben gezeigt, dass mit solchen Schichtdicken ein Nachschärfen der Schneidkante vermieden und eine lange Standzeit erreicht werden kann. Die Hartstoffschicht besteht vorzugsweise aus Verbindungen von Metallen der Gruppen IVa, Va, VIa der Periodentabelle mit den Elementen Bor, Kohlenstoff, Stickstoff oder Sauerstoff. Sie kann TiC, TiN, TiCN, TiAlN, WC, Al₂O₃, BC, SiC, VC, CrN, CrBN, CrCN, CrAlN, CrSiN, CrTiN, AlTiN, AlTiCrN, BN, ZrN, ZrCN, AlCrN, Ti2N, SixNy, oder Mischverbindungen von zwei oder mehreren der vorerwähnten Materialien als wesentlichen Bestandteil enthalten oder vollständig aus diesen bestehen.

Die Hartstoffschicht hat vorzugsweise eine Vicker's Härte (VH) zwischen 1000 und 5000 und vorzugsweise zwischen 2000 und 4000 HV. Ausserdem kann die Hartstoffschicht als Gradientenschicht ausgebildet sein, in welcher der relative Anteil eines oder mehrerer Metalle, insbesondere von Chrom, von innen nach aussen, abnimmt.

Das Grundmaterial des Holzbearbeitungswerkzeugs kann HSS, Hartmetall, Cermet oder Keramik sein. Vorteilhaft ist der Grundkörper des Werkzeugs eine Hartlegierung mit Anteilen von Chrom, Wolfram, Nickel, Molybdän, Kobalt, Eisen und/oder Kohlenstoff ist. Dabei kann auf das Grundmaterial des Werkzeugkörpers zuerst auch eine metallische Haftschicht, vorzugsweise enthaltend Übergangsmetalle, aufgebracht sein. Die Hartstoffschicht kann einoder mehrlagig sein, wobei zwischen den einzelnen Hartstoffschichten auch metallische Zwischenschichten, insbesondere solche mit Übergangsmetallen, vorhanden sein können.

Die Erfindung betrifft weiterhin ein Verfahren zum Herstellen eines erfindungsgemässen Holzbearbeitungswerkzeugs, wobei das Holzbearbeitungswerkzeug unter Verwendung eines PVD-Verfahrens, insbesondere eines Lichtbogen-Verdampfungs-Verfahrens beschichtet wird.

Dabei kommt im Prinzip jedes an sich bekannte und geeignete Verfahren der vorgenannten Art zur Herstellung eines erfindungsgemässen Holzbearbeitungswerkzeugs in Frage, wobei bevorzugt die Beschichtung unter Verwendung von nur einer Verdampferkathode bewerkstelligt wird.

Bei einem für die Praxis besonders wichtigen Ausführungsbeispiel für ein erfindungsgemässes Verfahren, wird ein Holzbearbeitungswerkzeug gemäss dem folgenden speziellen Verfahrensablauf beschichtet:
Bereitstellen einer Vakuum-Beschichtungskammer mit einer Lichtbogen-Verdampfungsquelle und Platzieren eines Schneidwerkzeugs an einem beweglichen Substrathalter der Beschichtungskammer. Sodann Erzeugung eines Hochvakuums in der Beschichtungskammer und Erhöhung der Temperatur auf 100-600° C, bevorzugt 400-600° C, für eine Stunde mittels eines Strahlungsheizers. Die zu beschichtende Oberfläche des Schneidwerkzeugs wird dabei für ca. 5-60 min, bevorzugt 15-35 min, mittels Ar-lonen einer Ionenreinigung unterzogen. Anschließend wird auf die gereinigte Oberfläche des Schneidwerkzeugs eine vorzugsweise 0,5 bis 3 um dicke Hartstoffschicht, vorzugsweise eine Cr-haltige Schicht, mittels Lichtbogen-Verdampfung unter Verwendung einer Bias-Vorspannung von 10-1000 V abgeschieden. Zur Verbesserung der Haftung kann vorgängig auch eine metallische Haftschicht aus Mo, Cr, Ti, Zr, Si, Al, W, Nb, Ta, B oder Mischungen und Verbindungen derselben auf der Oberfläche des Schneidwerkzeugs aufgebracht werden. Zur Abscheidung einer CrN - Schicht wird ein Stickstoffgas in die Beschichtungskammer eingelassen. Die Bias-Spannung wird dabei auf einen Wert zwischen 20 und 200 V eingestellt. Denkbar ist, eine CrN-Gradienten-Teilschicht aufzubringen, indem während der Abscheidung der CrN-Gradienten-Teilschicht der Stickstoff Partialdruck linear von 0.2 Pa auf bis zu 20 Pa erhöht wird, bis eine Schichtdicke der CrN-Gradienten-Teilschicht von 1 bis 3 mm erreicht wird. Anschliessend wird vorzugsweise einer weiteren Beschichtungsanlage mittels eines allgemein bekannten Magnetron-Sputter-Verfahrens Molybdändisulfid in einer Dicke von 0.5 bis 3 Mikrometer aufgetragen. Molybdändisulfid kann dabei durch Verdampfen von Molybdän und gleichzeitigem Einlassen eines schwefelhaltigen Gases gebildet werden. Alternativ kann ein MoS₂ Target verwendet und MoS₂ aufgesputtert werden. Letzteres Verfahren ist bevorzugt, weil die damit hergstellten Gleitschichten eine lange Standzeit des beschichteten Werkzeugs ergeben.

Ausführungsbeispiele der Erfindung werden nachfolgend anhand der Figuren beispielhaft beschrieben. Es zeigt:
- Fig. 1: Eine Darstellung der Verschleissformen in der Holzbearbeitung;
- Fig. 2: Im Vergleich eine unbeschichtete (links) und eine beschichtete Schneidkante des Stands der Technik (rechte Figur);
- Fig. 3: Kantenverrundung ohne Beschichtung in Funktion der Laufmeter;
- Fig. 4: Kantenverrundung mit Beschichtung in Funktion der Laufmeter.

Figur 1 zeigt Verschleissformen in der Holzbearbeitung, wie dies im in der Dissertation von K. Reh, TU Dresden (2001) beschrieben wird. Der Pfeil r bezeichnet dabei die Schneidkantenverrundung. An der Freifläche des Schneidwerkzeugs können zusätzlich folgende Verschleissparameter definiert werden:
- aₘ: Mikrofreiwinkel
- h1: Verschleissmass
- B: Verschleissmarkenbreite

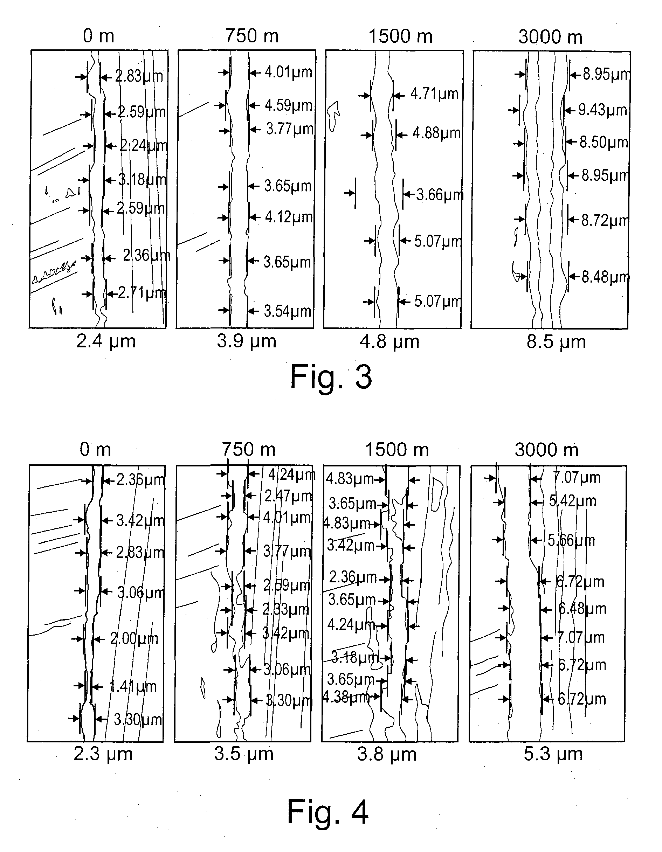

Die Figur 2 zeigt in der linken Darstellung den Schneidkeil 13 eines unbeschichteten Holzbearbeitungswerkzeugs 11. Dabei ist mit der Bezugsnummer 15 die Spanfläche und mit der Bezugsnummer 17 die Freifläche bezeichnet. Die Spanfläche 15 und die Freifläche 17 sind durch die Schneidkante 19 voneinander getrennt. Auf der rechten Seite ist der gleiche Schneidkeil 13 mit einer Beschichtung 21 gezeigt. Wie aus Figur 2 (vgl. auch Figur 4 der US 7,147,939) ersichtlich ist, wird allgemein davon ausgegangen, dass durch eine Beschichtung der Schneidkante die Schneidkantenverrundung deutlich zunimmt. Vorliegend würden die Beschichtungen mehr als eine Verdoppelung des Schneidkantenradius bewirken.

### Anwendungsbeispiel 1

Ein Holzschneidwerkzeug A mit einer definierten Kantenverrundung wird mittels eines allgemein bekannten PVD-Arc-Verfahren in einer Beschichtungsanlage gemäss EP 1 524 329 A1 oder WO 0250865 mit einer Chromhaltigen Grundschicht, zB CrN, beschichtet. Die Schichtdicke der CrN - Schicht beläuft sich auf ungefähr 1-3 Mikrometer.
Anschliessend wird auf das Werkzeug A in einer weiteren Beschichtungsanlage mittels eines allgemein bekannten Magnetron-Sputter-Verfahrens Molybdändisulfid in einer Dicke von ungefähr 1 Mikrometer aufgetragen.
Die gemessene Kantenverrundung beträgt nach der Beschichtung 2 - 4 Mikrometer. Ein Nachschleifen ist somit nicht nötig.

Die Kantenverrundung wurde vor und nach dem Beschichten auf einem Rasterelektronenmikroskop überprüft (Figuren 3 und 4).

Das Werkzeug wurde anschliessend auf einer Holzfräsmaschine vom Typ Conturex der Firma Michael Weinig AG eingesetzt. Die Fräsparameter waren wie folgt:

| | |
|---|---|
| Drehzahl: | 12'000 U/min, |
| Vorschub: | 12'000 mm/min. |

Nach 750, 1500 und 3000 Laufmetern wurde die Schneidkantenverrundung mittels eines Rasterelektronenmikroskops gemessen. Die Restfeuchtigkeit des Holzes betrug während den Versuchen 10 - 14 %. Die Zunahme der Kantenverrundung kann durch die Beschichtung signifikant verlangsamt werden. Die erhöhte Verschleissfestigkeit bedeutet gleichzeitig eine Erhöhung der Standzeit also der zu leistenden Laufmeter.

Die Resultate sind in Tab. 1 festgehalten.

**Tab 1. Kantenverrundung (in µm) in Funktion der Laufmeter**

| Laufmeter | **0 m** | **750 m** | **1500 m** | **3000 m** |
|---|---|---|---|---|
| Radius Blank [um] | 2.4 | 3.9 | 4.8 | 8.5 |
| Radius Beschichtet [um] | 2.3 | 3.5 | 3.8 | 5.3 |

Die Erfindung betrifft ein beschichtetes Holzbearbeitungswerkzeug, insbesondere Zerspanungswerkzeug, mit einem einen Schneidteil aufweisenden Werkzeugkörper, an welchem Schneidteil eine Schneidkante ausgebildet ist. Wenigstens die Spanfläche und vorzugsweise die Span- und Freifläche, sowie die Schneidkante des Schneidteils sind mit einer Hartstoffschicht und einer darüber angeordneten Gleitschicht beschichtet. Die Gleitschicht besteht vorzugsweise im Wesentlichen aus Sulfiden, Telluriden oder Seleniden mit Übergangsmetallen, insbesondere mit Mo, Nb, Ta, W, Nb, Ta. Bevorzugt besteht die Gleitschicht im Wesentlichen aus MoS₂ vorzugsweise hexagonaler Gitterstruktur und in im Wesentlichen stöchiometrischer Zusammensetzung, wobei Abweichungen von ± 20%, vorzugsweise von weniger als ±10 % und besonders bevorzugt weniger als ± 5 % sind möglich. In der Praxis ist die Abweichung von der stöchiometrischen Zusammensetzung vorzugsweise < 1% und besonders bevorzugt <0. 3 %. Eine solche Schicht ist durch Zerstäuben eines MoS₂ Target in einem bekannten Magnetron-Sputter-Verfahrens erhältlich. Die Erfindung betrifft ein beschichtetes Holzbearbeitungswerkzeug 11, insbesondere Zerspanungswerkzeug, mit einem einen Schneidteil 13 aufweisenden Werkzeugkörper, an welchem Schneidteil 13 eine Schneidkante 19 ausgebildet ist. Wenigstens die Spanfläche 15 und vorzugsweise die Span- und Freifläche 15,17, sowie die Schneidkante 19 des Schneidteils sind mit wenigstens einer Hartstoffschicht und einer darüber angeordneten Gleitschicht beschichtet. Die Gleitschicht besteht vorzugsweise im Wesentlichen aus Sulfiden, Telluriden oder Seleniden mit einem Übergangsmetall der Nebengruppe Va und VIa des Periodensystems insbesondere mit Mo, Nb, Ta, W, Nb, Ta.

## Patentansprüche

1. Beschichtetes Holzbearbeitungswerkzeug (11) mit einem einen Schneidteil (13) aufweisenden Werkzeugkörper, an welchem Schneidteil eine Schneidkante (19) ausgebildet ist und wenigstens die Spanfläche (15) des Schneidteils mit einer Hartstoffschicht (21) beschichtet ist, und der Keilwinkel des Schneidteils weniger als 65 Grad beträgt,
**dadurch gekennzeichnet,**
**dass** auf der Hartstoffschicht (21) zusätzlich eine Gleitschicht enthaltend Sulfide, Telluride und/oder Selenide aufgebracht ist.

2. Holzbearbeitungswerkzeug nach Anspruch 1, **dadurch gekennzeichnet, dass** die Gleitschicht MoS₂, NbS₂, TaS₂, WS₂, MoSe₂, NbSe₂, TaSe₂, WSe₂, MoTe₂, NbTe₂, WTe₂ oder Mischverbindungen als wesentlichen Bestandteil davon enthält.

3. Holzbearbeitungswerkzeug nach Anspruch 1 oder 2, **dadurch gekennzeichnet, dass** die Stärke der Gleitschicht eine untere Grenze von 0.2 µm, vorzugsweise 0.5 µm, und besonders bevorzugt von 0.8 µm, und eine obere Grenze von 3 µm, vorzugsweise 2 µm, und besonders bevorzugt von 1.5 µm aufweist.

4. Holzbearbeitungswerkzeug nach einem der Ansprüche 1 bis 3, **dadurch gekennzeichnet, dass** die Schneidkantenverrundung nach der Beschichtung < 10 µm beträgt.

5. Holzbearbeitungswerkzeug nach einem der Ansprüche I bis 4, **dadurch gekennzeichnet, dass** die Schneidkantenverrundung nach Aufbringung der Gleitschicht < 5 µm, vorzugsweise zwischen 1.5 µm und 4 µm, und besonders bevorzugt zwischen 2 µm und 3.5 µm beträgt.

6. Holzbearbeitungswerkzeug nach einem der Ansprüche 1 bis 5, **dadurch gekennzeichnet, dass** die Stärke der Hartstoffschicht eine untere Grenze von 0.5 µm, vorzugsweise 1 µm, und besonders bevorzugt von 1.5 µm, und eine obere Grenze von 7 µm, vorzugsweise 5 µm, und besonders bevorzugt von 3.5 µm aufweist.

7. Holzbearbeitungswerkzeug nach einem der Ansprüche 1 bis 6, **dadurch gekennzeichnet, dass** die Hartstoffschicht TiC, TiN, TiCN, TiAlN, WC, Al₂O₃, BC, SiC, VC, CrN, CrBN, CrCN, CrAlN, CrSiN, CrTiN, AlTin, AlTiCrN, BN, ZrN, ZrCN, AlCrN, Ti2N, SixNy oder deren Mischverbindungen sowie nanostrukturierte Schichten bestehend aus letzteren genannten Verbindungen von zwei oder mehreren vorerwähnten Materialien als wesentlichen Bestandteil enthalten.

8. Holzbearbeitungswerkzeug nach einem der Ansprüche 1 bis 7, **dadurch gekennzeichnet, dass** die Hartstoffschicht Chrom und/oder Titan und/oder Aluminium und/oder Silicium und/oder Zirkon oder Mischverbindungen derselben, aber bevorzugt Chrom, enthält, und eine Stärke zwischen 0.4 und 5 µm, vorzugsweise zwischen 0.6 und 4 µm, und besonders bevorzugt zwischen 0.8 und 3 µm besitzt, und dass die Gleitschicht MoS₂, NbS₂, TaS₂, WS₂, MoSe₂, NbSe₂, TaSe₂, WSe₂, MoTe₂, NbTe₂, WTe₂ oder Mischverbindungen von zwei oder mehreren der vorgenannten Verbindungen enthält und eine Stärke zwischen 0.1 und 3 µm, vorzugsweise zwischen 0.2 und 2 µm, und besonders bevorzugt zwischen 0.3 und 1.5 µm besitzt

9. Holzbearbeitungswerkzeug nach einem der Ansprüche 1 bis 8, **dadurch gekennzeichnet, dass** die Hartstoffschicht chromhaltig ist und CrN, CrBN, CrCN, CrAlN, CrSiN, CrTiN, AlTiCrN, ZrCN oder AlCrN, gegebenenfalls mit anderen Hartstoffverbindungen enthält.

10. Holzbearbeitungswerkzeug nach einem der Ansprüche 1 bis 9, **dadurch gekennzeichnet, dass** auf der Hartstoffschicht eine MoS₂ - Schicht mit hexagonaler Gitterstruktur aufgebracht ist.

11. Holzbearbeitungswerkzeug nach einem der Ansprüche 1 bis 10, **dadurch gekennzeichnet, dass** der Keilwinkel des Schneidteils zwischen etwa 40 und 60 Grad, und besonders bevorzugt zwischen ca. etwa 45 und 55 Grad beträgt.

12. Holzbearbeitungswerkzeug nach einem der Ansprüche 1 bis 11, **dadurch gekennzeichnet, dass** der Grundkörper des Werkzeugs aus HSS, Hartmetall, Cermet oder Keramik besteht.

13. Holzbearbeitungswerkzeug nach einem der Ansprüche I bis 12, **dadurch gekennzeichnet, dass** der Grundkörper des Werkzeugs eine Hartlegierung ist und Anteile von Chrom, Kobalt, Eisen, Nickel, Wolfram, Molybdän und/oder Kohlenstoff enthält, dass die Hartstoffschicht aus CrN besteht und ungefähr eine Dicke zwischen 1 und 3 Mikrometer aufweist, und dass die Gleitschicht im Wesentlichen aus MoS₂ mit hexagonaler Gitterstruktur und in im Wesentlichen stöchiometrischer Zusammensetzung besteht.

14. Verfahren zur Herstellung eines beschichteten Schneidwerkzeugs für die Holzbearbeitung, bei welchem Verfahren wenigstens die Spanfläche besonders bevorzugt das ganze Schneidteil (13) des Schneidwerkzeugs mit einer Hartstoffschicht beschichtet wird,
**dadurch gekennzeichnet,**
**dass** auf die Hartstoffschicht eine Gleitschicht enthaltend Sulfide, Telluride und/oder Selenide mit wenigstens einem Übergangsmetall der Nebengruppe Vb oder VIb des Periodensystems, aufgebracht wird.

15. Verfahren nach Anspruch 14, **dadurch gekennzeichnet, dass** als Hartstoffschicht eine eine Chromverbindung enthaltende Grundschicht, gegebenenfalls in Kombination mit anderen keramischen Hartstoffverbindungen, und anschliessend eine MoS₂-Gleitschicht, durch Aufsputtern von MoS₂ in einem PVD - Verfahren, aufgebracht wird.

16. Verfahren nach Anspruch 14 oder 15, **dadurch gekennzeichnet, dass** eine Schneidkante mit einer Schneidkantenverrundung < 7 µm, vorzugsweise < 4 µm und besonders bevorzugt zwischen 2 µm und 7 µm bereitgestellt und diese dann beschichtet wird.

## Claims

1. Coated wood working tool (11) with a tool body having a cutting part (13), cutting part on which a cutting edge (19) is formed and at least the first face (15) of the cutting part is coated with a hard material layer (21) and the wedge angle of the cutting part is less than 65 degrees, **characterized in that** a sliding layer containing sulfides, tellurides and/or selenides is additionally applied on the hard material layer (21).

2. Wood working tool according to claim 1, **characterized in that** the sliding layer contains MoS₂, NbS₂, TaS₂, WS₂, MoSe₂, NbSe₂, Tastes, WSe₂, MoTe₂, NbTe₂, Wte₂ or mixed compounds as essential constituent thereof.

3. Wood working tool according to claim 1 or 2, **characterized in that** the thickness of the sliding layer has a lower bound of 0,2 µm, preferably of 0,5 µm and most preferably of 0,8 µm and an upper bound of 3 µm, preferably of 2 µm and most preferably of 1,5 µm.

4. Wood working tool according to one of the claims 1 to 3, **characterized in that** the cutting edge rounding after coating is < 10 µm.

5. Wood working tool according to one of the claims 1 to 4, **characterized in that** the cutting edge rounding after application of the sliding layer is < 5 µm, preferably between 1,5 and 4 µm and most preferably between 2 µm and 3,5 µm.

6. Wood working tool according to one of the claims 1 to 5, **characterized in that** the thickness of the hard material layer has a lower bound of 0,5 µm, preferably of 1 µm and most preferably of 1,5 µm and an upper bound of 7 µm, preferably of 5 µm and most preferably of 3,5 µm.

7. Wood working tool according to one of the claims 1 to 6, **characterized in that** the hard material layer contains TiC, TiN, TiCN, TiAlN, WC, Al₂O₃, BC, SiC, VC, CrN, CrBN, CrCN, CrAlN, CrSiN, CrTiN, AlTin, AlTiCrN, BN, ZrN, ZrCN, AlCrN, Ti2N, SixNy or their mixed compounds as well as nanostructured layers consisting of the last mentioned compounds of two or more materials mentioned above as essential constituent.

8. Wood working tool according to one of the claims 1 to 7, **characterized in that** the hard material layer contains chrome and/or titanium and/or aluminum and/or silicium and/or zircon or mixed compounds thereof but preferably chrome and has a thickness between 0,4 and 5 µm, preferably between 0,6 and 4 µm and most preferably between 0,8 and 3 µm and that the sliding layer contains MoS₂, NbS₂, TaS₂, WS₂, MoSe₂, NbSe₂, TaSe₂, WSe₂, MoTe₂, NbTe₂, Wte₂ or mixed compounds of two or more of the compounds mentioned above and has a thickness between 0,1 and 3 µm, preferably between 0,2 and 2 µm and most preferably between 0,3 and 1,5 µm.

9. Wood working tool according to one of the claims 1 to 8, **characterized in that** the hard material layer contains chrome and CrN, CrBN, CrCN, CrAlN, CrSiN, CrTiN, AlTin, AlTiCrN, BN, ZrN, ZrCN or AlCrN, if necessary with other hard material compounds.

10. Wood working tool according to one of the claims 1 to 9, **characterized in that** a MoS₂ layer with a hexagonal grid structure is applied on the hard material layer.

11. Wood working tool according to one of the claims 1 to 10, **characterized in that** the wedge angle of the cutting part is between approximately 40 and 60 degrees and most preferably between approximately 45 and 55 degrees.

12. Wood working tool according to one of the claims 1 to 11, **characterized in that** the base body of the tool is made of HSS, hard metal, cermet or ceramics.

13. Wood working tool according to one of the claims 1 to 12, **characterized in that** the base body of the tool is a hard alloy and contains parts of chrome, cobalt, iron, nickel, tungsten, molybdenum and/or carbon, that the hard material layer is made of CrN and has an approximate thickness between 1 and 3 micrometers and that the sliding layer essentially consists of MoS₂ with a hexagonal grid structure and has a substantially stoichiometric composition.

14. Method for producing a coated cutting tool for wood working, method for which at least the first face, most preferably the whole cutting part (13) of the cutting tool, is coated with a hard material layer, **characterized in that** a sliding layer containing sulfides, tellurides and/or selenides with at least one transition metal of the coset Vb or Vlb of the classification of elements is applied on the hard material layer.

15. Method according to claim 14, **characterized in that** a basic layer containing a chrome compound, if necessary combined with other ceramic hard material compounds, is applied as hard material layer and consecutively a MoS₂ sliding layer by sputtering of MoS₂ in a PVD process.

16. Method according to claim 14 or 15, **characterized in that** a cutting edge with a cutting edge rounding of < 7 µm, preferably of < 4 µm and most preferably between 2 µm and 7 µm is made available and is then coated.

## Revendications

1. Outil revêtu pour le travail du bois (11) avec un corps d'outil qui présente une partie coupante (13), partie coupante sur laquelle une arête tranchante (19) est formée et au moins la face de coupe (15) de la partie coupante est revêtue d'une couche de matériau dur (21) et l'angle de tranchant de la partie coupante est inférieur à 65 degrés,
**caractérisé en ce qu'**en plus une couche de glissement qui contient des sulfures, des tellurures et/ou des séléniures est appliquée sur la couche de matériau dur (21).

2. Outil pour le travail du bois selon la revendication 1, **caractérisé en ce que** la couche de glissement contient du MoS₂, du NbS₂, du TaS₂, du WS₂, du MoSe₂, du NbSe₂, du TaSe₂, du WSe₂, du MoTe₂, du NbTe₂, du Wte₂ ou des composés mixtes comme composant essentiel de celle-ci.

3. Outil pour le travail du bois selon la revendication 1 ou 2, **caractérisé en ce que** l'épaisseur de la couche de glissement présente un seuil inférieur de 0,2 µm, de préférence de 0,5 µm et de manière particulièrement préférée de 0,8 µm et un seuil supérieur de 3 µm, de préférence de 2 µm et de manière particulièrement préférée de 1,5 µm.

4. Outil pour le travail du bois selon l'une des revendications 1 à 3, **caractérisé en ce que** l'arrondissement de l'arête tranchante après le revêtement est < 10 µm.

5. Outil pour le travail du bois selon l'une des revendications 1 à 4, **caractérisé en ce que** l'arrondissement de l'arête tranchante après l'application de la couche de glissement est < 5 µm, de préférence entre 1,5 µm et 4 µm et de manière particulièrement préférée entre 2 µm et 3,5 µm.

6. Outil pour le travail du bois selon l'une des revendications 1 à 5, **caractérisé en ce que** l'épaisseur de la couche de matériau dur présente un seuil inférieur de 0,5 µm, de préférence de 1 µm et de manière particulièrement préférée de 1,5 µm et un seuil supérieur de 7 µm, de préférence de 5 µm et de manière particulièrement préférée de 3,5 µm.

7. Outil pour le travail du bois selon l'une des revendications 1 à 6, **caractérisé en ce que** la couche de matériau dur contient du TiC, du TiN, du TiCN, du TiAlN, du WC, de l'Al₂O₃, du BC, du SiC, du VC, du CrN, du CrBN, du CrCN, du CrAlN, du CrSiN, du CrTiN, de l'AlTin, de l'AlTiCrN, du BN, du ZrN, du ZrCN, de l'AlCrN, du Ti2N, du SixNy ou des composés mixtes ainsi que des couches nanostructurées constituées par les derniers composés cités de deux ou de plusieurs matériaux mentionnés ci-dessus comme composant essentiel.

8. Outil pour le travail du bois selon l'une des revendications 1 à 7, **caractérisé en ce que** la couche de matériau dur contient du chrome et/ou du titane et/ou de l'aluminium et/ou du silicium et/ou du zircone ou des composés mixtes de ceux-ci mais de préférence du chrome et présente une épaisseur entre 0,4 et 5 µm, de préférence entre 0,6 et 4 µm et de manière particulièrement préférée entre 0,8 et 3 µm et que la couche de glissement contient du MoS₂, du NbS₂, du TaS₂, du WS₂, du MoSe₂, du NbSe₂, du TaSe₂, du WSe₂, du MoTe₂. du NbTe₂, du Wte₂ ou des composés mixtes de deux ou de plusieurs matériaux mentionnés ci-dessus et a une épaisseur entre 0,1 et 3 µm, de préférence entre 0,2 et 2 µm et de manière particulièrement préférée entre 0,3 et 1,5 µm.

9. Outil pour le travail du bois selon l'une des revendications 1 à 8, **caractérisé en ce que** la couche de matériau dur contient du chrome et du CrN, du CrBN, du CrCN, du CrAlN, du CrSiN, du CrTiN, de l'AlTin, de l'AlTiCrN, du BN, du ZrN, du ZrCN ou de l'AlCrN, le cas échéant avec d'autres composés de matériau dur.

10. Outil pour le travail du bois selon l'une des revendications 1 à 9, **caractérisé en ce qu'**une couche de MoS₂ avec une structure réticulaire hexagonale est appliquée sur la couche de matériau dur.

11. Outil pour le travail du bois selon l'une des revendications 1 à 10, **caractérisé en ce que** l'angle de tranchant de la partie coupante est entre environ 40 et 60 degrés et de manière particulièrement préférée entre environ 45 et 55 degrés.

12. Outil pour le travail du bois selon l'une des revendications 1 à 11, **caractérisé en ce que** le corps de base de l'outil est constitué en HSS, en métal dur, en cermet ou en céramique.

13. Outil pour le travail du bois selon l'une des revendications 1 à 12, **caractérisé en ce que** le corps de base de l'outil est un alliage dur et contient des fractions de chrome, de cobalt, de fer, de nickel, de tungstène, de molybdène et/ou de carbone et que la couche de matériau dur est en CrN et présente une épaisseur à peu près entre 1 et 3 micromètres et que la couche de glissement est essentiellement constituée par du MoS₂ avec une structure réticulaire hexagonale et de composition substantiellement stoechiométrique.

14. Procédé pour la fabrication d'un outil de coupe revêtu pour le travail du bois, procédé pour lequel au moins la face tranchante, de préférence toute la partie coupante (13) de l'outil de coupe, est revêtue d'une couche de matériau dur, **caractérisé en ce qu'**une couche de glissement qui contient des sulfures, des tellurures et/ou des séléniures est appliquée sur la couche de matériau dur avec au moins un métal transitoire du groupe associé Vb ou VIb du système périodique.

15. Procédé selon la revendication 14, **caractérisé en ce qu'**une couche de base qui contient un composé à base de chrome, le cas échéant en combinaison avec d'autres combinaisons de matériaux durs céramiques est appliquée comme couche de matériau dur et ensuite une couche de glissement en MoS₂ par pulvérisation cathodique de MoS₂ dans un dépôt en phase gazeuse par procédé physique.

16. Procédé selon la revendication 14 ou 15, **caractérisé en ce qu'**une arête tranchante avec un arrondissement < 7 µm, de préférence < 4 µm et de manière particulièrement préférée entre 2 µm et 7 µm est mise à disposition et est ensuite revêtue.
